# EUROPEAN PATENT SPECIFICATION

(11) **EP 0 410 373 B1**
(45) Date of publication and mention of the grant of the patent: **04.01.1995**
(21) Application number: 90114151.5
(22) Date of filing: 24.07.1990
(51) Int. Cl.: H01L 39/24

(54) **Method for forming a superconducting circuit**
Verfahren zur Herstellung einer supraleitenden Schaltung
Méthode pour formation de circuit supraconducteur

(30) Priority: 24.07.1989 JP 191019/89
(43) Date of publication of application: 30.01.1991
(73) Proprietor: THE FURUKAWA ELECTRIC CO., LTD., Tokyo (JP)
(72) Inventor: Shiga, Shoji, c/o THE FURUKAWA ELEC. CO., LTD., Chiyoda-ku, Tokyo (JP); Sato, Koki, c/o THE FURUKAWA ELEC. CO., LTD., Chiyoda-ku, Tokyo (JP); Harada, Nakahiro, c/o THE FURUKAWA ELEC. CO., LTD., Chiyoda-ku, Tokyo (JP); Yamamoto, Kiyoshi, c/o THE FURUKAWA ELEC. CO., LTD, Chiyoda-ku, Tokyo (JP)
(74) Representative: Lehn, Werner, Dipl.-Ing.

(56) References cited:
- EP-A- 0 276 746
- PROCEEDINGS INTERNATIONAL ELECTRON DEVICES MEETING, San Francisco, CA, 11th -14th December 1988, pages 282-285; A. YOSHIDA et al.: "Monolithic device fabrication using high-Tc superconductor"
- PATENT ABSTRACTS OF JAPAN, vol. 13, no. 62 (E-715)[3410], 13th February 1989; & JP-A-63 250 880
- PHYSICAL REVIEW B, vol. 35, no. 16, 1st June 1987, pages 8782-8784, New York,US; G. XIAO et al.: "Effect of transition-metal elements on thesuperconductivity of Y-Ba-Cu-O"
- Physics Today, April 1988, pp. 21-25
- WO 89/10634

## Description

The present invention relates to a method for forming a superconducting circuit for use in, for example, an electronic circuit element or substrate therefor. Such a method is disclosed in EP-A-0276746.

In place of a metal superconductor which produces a superconducting phenomenon at a very low temperature of liquid helium, a ceramics superconductor has been newly highlighted and actively developed in recent times, namely a ceramics superconductor producing a superconducting phenomenon at a temperature exceeding a liquid nitrogen temperature, that is, a ceramics superconductor whose critical temperature Tc is above the liquid nitrogen temperature. A recent attention has been focused particularly on a Y-Ba-Cu-O based one, such as YBa₂Cu₃O₇-d (d = 0 to 0.5) (Tc = 90 to 95 K), including one obtained by replacing Y with rare earth elements; a Bi-Sr-Ca-Cu-0 based one, such as Bi₂Sr₂CaCu₂0₈ and Bi₂Sr₂Ca₂Cu₃0₁₀ (Tc = 80 to 110 K); and a Tl-Ba-Ca-Cu-0 based one, such as Tl₂Ba₂CaCu₂O₆, Tl₂Ba₂Ca₂Cu₃O₁₀ and TlBa₂Ca₂Cu₃0_{8.5} (Tc = 90 to 125 K), and one obtained by partially replacing Bi, Tl of the aforementioned two superconductors with Pb, Sb, In.

Since the ceramics superconductor displays an excellent electrical property at the critical temperature exceeding the liquid nitrogen temperature, it is useful as, for example, an electronic element, an electric cable, a magnetic coil, a circuit conductor and a magnetic shield.

A method for forming a superconducting circuit is by forming a pattern, like an ordinary circuit board conductor formation method, with the use of a photosensitive resist resin and performing an etching step (a dry or a wet etching step) with the pattern used as an etching mask.

This method, however, has a drawback in that an overetch and/or side-etch during the etching step can have adverse effects on the conductive properties of the work piece and dimensional errors in the circuit section obtained. Furthermore, as non-circuit portions are formed by removal of material in the etching step, an unevenness (a step) is formed at the junction of each circuit and non-circuit section, adversely affecting the flatness of the substrate and hence presenting a problem in the provision of, for example, further elements in and on the substrate surface. It is, therefore, necessary to provide an insulation layer over the non-circuit portions to lessen the uneven surfaces of the circuit and non-circuit sections.

It is accordingly the object of the present invention to provide a method for forming a superconducting circuit which can ensure an excellent flatness, in which the formation of a multi-layer structure and the rapid formation of a desired fine pattern, presents no specific etching problem, such as a side-etch, and can be applied to a ceramics superconductor which is well-suited to use for electronic devices, etc. and which is readily subjected to a cooling at a critical temperature exceeding a liquid nitrogen temperature.

In one aspect of the present invention, there is provided a method for forming a superconducting circuit, with the characterising features of claim 1 below.

A multi-layered superconducting circuit is created by sequentially repeating the steps of forming a superconducting layer, by an epitaxial growth, as a second layer on a partially modified superconducting layer which is formed as a first layer; forming a mask pattern on a second superconducting layer; covering the masked superconducting layer with a covering layer containing a modifying element for superconductor, on the surface of a resultant structure; and diffusing the modifying element for superconductor, which is contained in the covering layer, into the corresponding superconducting layer to modify a corresponding location to a nonsuperconducting layer.

This invention can be more fully understood from the following detailed description when taken in conjunction with the accompanying drawings, in which:
Fig. 1 is a cross-sectional view showing a multi-layered circuit which is obtained by a method for forming a superconducting circuit of the present invention;
Figs. 2A, 2B, 2C and 2D are cross-sectional views showing successive steps for forming a superconducting circuit in the present invention; and
Figs. 3 and 4 are cross-sectional views showing other multi-layers circuits which are obtained by a method for forming a superconducting circuit of the present invention.

In the present invention,a superconductor for use as a superconducting layer may be of either a ceramics superconductor such as Y-Ba-Cu-0, Bi-Sr-Ca-Cu-0 and Tl-Ba-Ca-Cu-0 based superconductor.

A mask pattern is formed on a superconducting layer by a conventional method, such as photolithography.

In general, an ordinary method for forming a thin film, such as sputtering, vapor deposition and ion plating, may be employed to form a coating layer containing a superconductor-modifying element. The thickness of the covering layer can be so set as to modify a superconducting layer to allow its physical property, such as Tc, to vary. In the ceramics superconductor as set forth above, the choice of any particular element can largely vary the physical property of the superconductor of a thin film.

A suitable modifying element to be contained in the covering layer is one which can be diffused in the superconductor by a predetermined treatment to allow the superconductor to be modified, such as to vary Tc of the superconductor. Taking YBa₂Cu₃0₇ by way of example, many elements may be employed, but especially effective ones are those which replace Cu in the crystal structure, such as Zn, Al, Ga, Fe, Co, Ni, La, Cd and Be. This is because a high temperature superconductor containing a copper oxide has its copper, such as a Cu-0₂ plane, directly related to the superconductor. YBa₂Cu₃0₇ is orthorhombic, but Zn, Ni, etc. of the aforementioned modifying elements, while sustaining an orthorhombic structure, lessens Tc, etc., and are transformed into a form eventually classified as a tetragonal system whose lattice constant alone is somewhat different. Furthermore, Fe and Co, if added to the superconductor in a small quantity, are transformed into a tetragonal system with Tc gradually decreased.

The amount of modifying element, though depending upon the conditions employed, falls nearly within a 1 to 40% range based on the amount of superconductor and can experimentally be selected. Although the conditions underwhich an epitaxial growth is carried out cannot be uniformly determined depending also upon the deposition condition as well as the method and materials employed, the present invention is based on the conditions under which the superconductor is of an identical or nearly identical crystal structure, such as a tetragonal and an orthorhombic structure.

A suitable method for diffusing a modifying element for superconductor, contained in a covering layer, into the superconducting layer, is one which achieves this readily and rapidly. One such method is a thermal diffusion treatment in which the heating temperature is preferably 200° to 1000°C.

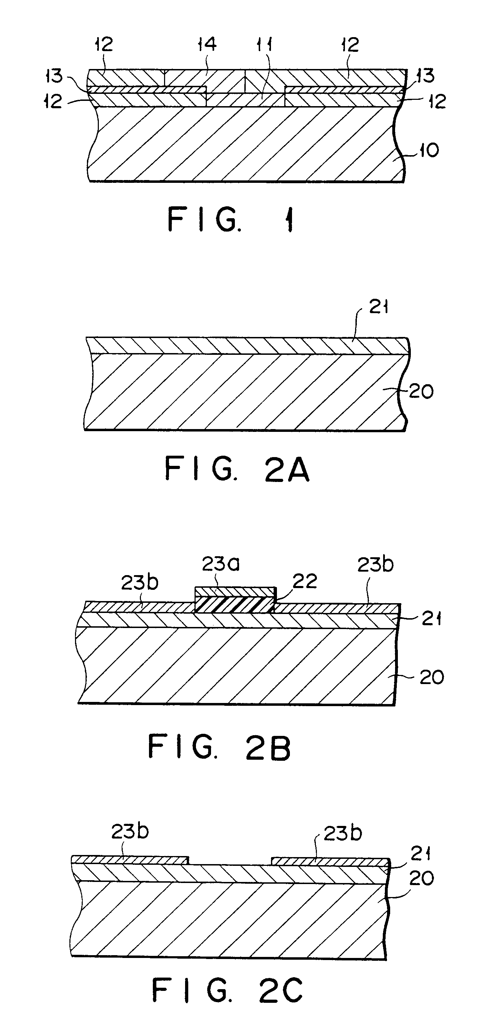

The steps of forming a superconducting layer, as a second layer, on a partially modified superconducting layer, forming a mask pattern on a resultant structure, forming a covering layer containing a modifying element for superconductor and diffusing the modifying element in the covering layer into the superconducting layer (second layer) are employed as in the formation of the first layer to provide a two- or more layered superconducting circuit. In order to prevent the modifying element in the covering layer which is diffused into one superconducting layer from being diffused into another superconducting layer, a buffer layer may be formed between an underlying superconducting layer and an overlying superconducting layer. The buffer layer serves the purpose if it has a crystal structure matching better to the superconductor, and may be selected from materials such as MgO, SrTi0₃, AlGa0₃, Zn02, BaZr0₃ and LaAl0₂. A conduction between the respective layers can be readily achieved, as shown in Fig. 1, by arranging a buffer layer 13 on only the non-circuit section 12 of the circuit section 11 and non-circuit section 12 both formed on the substrate 10 and overlapping arranging the circuit section 14 of the second layer on the circuit section 11 of the first layer.

The method for forming a superconducting circuit of the present invention comprises forming a mask pattern on a superconducting layer, forming a covering layer, containing a modifying element for superconductor on a resultant structure and diffusing the modifying element in the covering layer by a heating method to selectively modify the superconductor at a corresponding location. As a result, the non-circuit section of the superconducting layer has its critical temperature Tc dropped below less than 77 K, the temperature of liquid nitrogen at which a superconducting phenomenon occurs, so that the electrical resistance of the non-circuit section is increased. When this occurs, the circuit section alone becomes a conductor at the critical temperature Tc of the superconductor, creating a superconducting circuit.

It is, thus, possible according to the present invention to readily form a multi-layer superconducting circuit structure whose circuit surface is flat because an otherwise required etching step is avoided. In this case, the non-circuit section having its specific element diffused therein takes on a crystal structure nearly similar to a superconductor and a subsequent layer can be formed as an epitaxially oriented layer. According to the present invention, it is possible to realize a multi-layer structure where, for example, a c-axis of a practical crystal is oriented perpendicular to a substrate. A superconductor thus obtained displays an anisotropic crystal structure, such as a two-dimensional nature, and a better superconductivity.

The present invention will be explained below with reference to the accompanying drawings.

### Example 1

With an Mg0 (100)-face substrate mounted on a magnetron sputtering apparatus, YBa_{2.1}Cu_{2.2}0x was sputtered onto a substrate being heated to 650°C, with the use of a target of the ceramics superconductor YBa_{2.1}Cu_{2.2}0x (x = 7.1). By so doing, a 0.3 µm-thick superconducting layer was formed on the substrate. The sputtering was done under conditions of an electric power of 250 W and atmosphere gas pressure of 0.133 mbar (100 mTorr) (Ar + 50%0₂) with a c-axis orientation. Fig. 2A is a cross-sectional view showing a substrate with a superconducting layer formed thereon.

In Figs. 2A, 20 and 21 denote a substrate and superconducting layer, respectively. The substrate with the superconductor formed thereon was heated at 900°C for 30 minutes and thereafter annealed at a rate of 2°C/min.

The coating of a photosensitive resist resin as resist onto the superconducting layer 21 and the light exposure of the resultant structure were carried out in an ordinary method to form a 4 µm wide x 100 µm long mask pattern 22 with a 100 µm square pad formed at opposite ends (Fig. 2B).

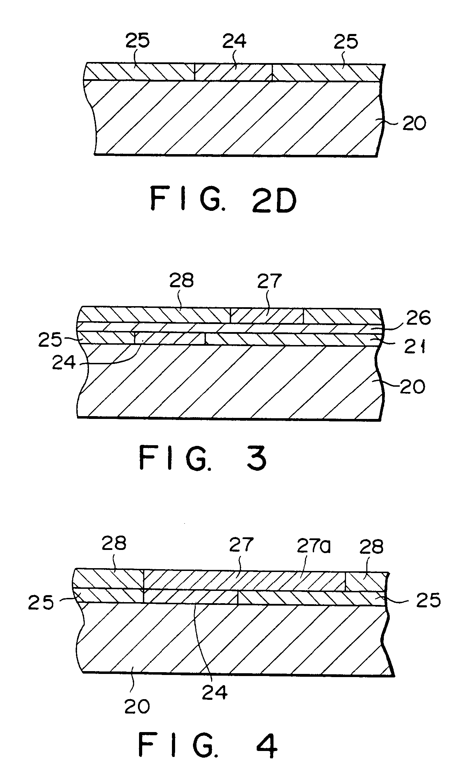

Sputtering was done onto the whole surface of a resultant structure in the same way as set forth above to form a Zn layer to a thickness of 0.04 µm. Fig. 2B is a cross-sectional view showing a substrate with a covering layer formed thereon. In Fig. 2B, 23a denotes a Zn layer corresponding to a circuit section formation area and 23b denotes a Zn layer corresponding to an area where no circuit section is formed, noting that these Zn layers are separate from each other in a manner to provide a stepped surface over the substrate. The mask pattern 22 and overlying Zn layer 23a were lifted off the substrate 20. Thereafter, the resultant substrate structure was heated for 2 hours at 450°C in an Ar gas stream and then for 4 hours at 500°C in an 0₂ stream with which that preceding gas atmosphere was replaced. In this way, Zn in the Zn layer 23b was diffused into the superconducting layer 21 to create a superconducting circuit. Fig 2C is a cross-sectional view showing a substrate structure with the Zn layer removed by a lift-off step and Fig. 2D is a cross-sectional view showing a substrate structure with the aforementioned thermal diffusion done. In Fig. 2D, 24 shows a circuit section and 25, a non-circuit section.

The circuit section of the superconducting circuit thus created revealed Tc = 85 K and Jc (current density) = 1.3 x 10⁶ A/cm² at 77 K. The non-circuit manifested Tc = 30 K in an ON set state, and an OFF set state of Tc showing an electrical resistance of zero was not actually evaluated until 4.2 K. The circuit and non-circuit sections, upon being analytically examined by an X-ray diffraction apparatus, revealed a c-axis oriented orthorhomic system having a lattice constant in the c-axis direction of 1.167 and 1.174 nm (11.67 Å and 11.74 Å), respectively.

### Example 2

A YBa_{2.1}Cu_{2.2}Ox superconducting circuit was created in the same method as in Example 1, except that a 0.03 µm thick Al layer was employed in place of the 0.04 µm thick Zn layer.

The circuit section of the superconducting circuit thus obtained was found to be Tc = 85° K and Jc = 1.2 x 10⁶ A/cm² at 77 K. The non-circuit section of the superconducting circuit sections of the superconducting circuit were analytically examined by an X-ray diffraction method, showing a c-axis oriented orthorhombic system having a lattice constant in the c-axis direction of 1.168 and 1.171 nm (11.68 Å and 11.71 Å), respectively.

### Example 3

A YBa_{2.1}Cu_{2.2}Ox superconducting circuit (first layer) was formed in the same method as in Example 1

A 0.05 µm-thick SrTi0₃ layer was formed, as a buffer layer, over the whole surface of the aforementioned superconductor circuit (first layer). A 0.3 µm-thick YBa_{2.1}Cu_{2.2}Ox superconducting circuit (second layer) was formed over the buffer layer in the same method as in Example 1. Fig. 3 is a cross-sectional view showing a substrate after the second layer (superconductor circuit) was formed, noting that 26 shows a buffer layer; 27, the circuit section of the second layer; and 28, a non-circuit section of the second layer.

The circuit section of the superconducting circuit was found to be Tc = 84 K and Jc = 1.05 x 106 A/cm² at 77 K. The circuit and non-circuit sections were analytically X-ray diffracted to exhibit a c-axis oriented orthorhombic system with their lattice constant in the x-axis direction of 1.166 and 1.173 nm (11.66 Å and 11.73 Å), respectively.

### Example 4

A two-layered superconducting circuit was formed, in the same method as in Example 3, except for the formation of a buffer layer.

The circuit section of the superconducting circuit thus obtained was found to be Tc = 84 K and Jc - 0.85 x 10⁶ A/cm² at 77 K. The circuit and non-circuit sections were analyzed by an X-ray diffraction method, revealing a c-axis oriented orthorhombic system having a lattice constant in the c-axis direction of 1.167 and 1.174 nm (11.67 Å and 11.74 Å), respectively.

### Example 5

A circuit (first layer) was formed as in the same method as in Example 2 and a second circuit (second layer ) was formed as in the same method as in Example 4 at which time the second layer (superconducting layer) was formed to a thickness of 0.6 µm and a modifying Al deposition layer was 0.03 µm in thickness. From Fig. 4 it is appreciated that the first and second layers (first and second circuits) 24 and 27 are conducted to each other. The circuit and non-circuit sections of the second layer, being examined by an X-ray diffraction method, were found to be a c-axis oriented orthorhombic system having lattice constant in the c-axis direction of 1.167 and 1.173 nm (11.67 Å and 11.73 Å), respectively. The first and second layers, being electrically connected together, were evaluated, showing Tc = 59 K and Jc = 1.3 x 10⁶ A/cm² at 77 K. The non-circuit section (the second layer) was found to be Tc = 59 K in an ON set state and Tc = 30 K in an OFF set state.

### Control 1

The circuit sections of the first and second layers were deposited, as in Example 3, to a thickness of 0.1 µm. When the non-circuit sections of the first and second layers were examined by an X-ray diffraction method, ZnO was detected there, hardly detecting the formation of a superconducting layer. The circuit section of the second layer was found not oriented in an c-axis direction and stayed at Tc = 80 K and Jc = 1.5 x 10³ A/cm².

### Control 2

An Al deposition layer was formed, as in Example 5, to a thickness of 0.1 µm and the non-circuit sections of the first and second layers revealed no superconductive phase. A circuit portion (corresponding to a section 27a in Fig. 4) overlying the non-circuit section of the first layer, which occupied the major section of the circuit section of the second layer, was analytically examined by an X-ray diffraction method, showing no specific crystal orientation. The circuits of the first and second layers, upon being evaluated there-through, stayed at Tc = 80 K and Jc = 0.9 x 10³ A/cm² at 77 K.

As set forth above, the present method for the manufacture of a superconducting circuit ensures a better planarization and a rapid formation of a desired, very fine pattern without causing any specific etch problem, such as a side-etch. The present method provides a multi-layered structure, to construct a superconductor-applied apparatus as a highly sophisticated unit.

Reference signs in the claims are intended for better understanding and shall not limit the scope.

## Claims

1. A method for forming a multi-layer superconducting circuit having multiple superconducting layers, comprising the steps of:
(1) epitaxially growing a ceramic superconducting layer (21) on a substrate (20);
(2) forming a mask pattern (22) on a circuit portion of said ceramic superconducting layer (21)
(3) covering the surface of said ceramic superconducting layer (21), including said circuit portion having said mask pattern (22) formed thereon and a non-circuit portion not having said mask pattern (22) formed thereon, with a covering layer (23a, 23b) comprising a modifying element for lowering the critical temperature of said ceramic superconducting layer (21);
(4) removing from said circuit portion of said ceramic superconducting layer (21) said mask pattern (22) together with said covering layer (23a) formed thereon to form a partially covered ceramic superconducting layer (21) still covered by said covering layer (23b) in said non-circuit portion;
(5) heating said partially covered ceramic superconducting layer (21) so as to thermally diffuse said modifying element from said covering layer (23b) into said non-circuit portion of said ceramic superconducting layer (21), thereby forming a layer of a superconducting circuit structure including a superconducting circuit portion and a non-superconducting non-circuit portion, said circuit portion having a critical temperature of more than 77 K, and said non-circuit portion having a critical temperature less than 77 K and a crystal structure the same as or similar to that of the circuit portion; and
(6) repeating at least once on said layer of said superconducting circuit structure said steps (1) to (5) to thereby form said multi-layer superconducting circuit having said multiple superconducting layers.

2. A method according to claim 1, wherein said modifying element is diffused in an amount that enables the superconductor after the diffusion to have a crystal structure the same as or similar to that of the superconductor before the diffusion.

3. A method according to claim 1 or 2, wherein said ceramics superconductor is a Y-Ba-Cu-0 based superconductor, a Bi-Sr-Ca-Cu-0 based superconductor or a Tl-Ba-Ca-Cu-0 based superconductor.

4. A method according to any one of the preceding claims, wherein said mask pattern (22) is formed by a photo-lithography method.

5. A method according to any one of the preceding claims, wherein said covering layer (23a, 23b), containing the said modifying element is formed by sputtering, vapor deposition or ion plating.

6. A method according to any one of the preceding claims, wherein said modifying element is at least one of Zn, Al, Ga, Fe, Co, Ni, La, Cd and Be.

7. A method according to any one of the preceding claims, wherein the heating step is performed at a temperature of 200°C to 1000°C.

8. A method according to any one of the preceding claims, wherein a buffer layer (26) is provided between said superconducting layers of said multi-layer superconducting circuit.

9. A method according to claim 8, wherein said buffer layer (26) comprises at least one of Mg0, SrTi0₃, AlGa0₃, Zn0₂, BaZr0₃ and LaAl0₂.

10. A method according to any one of the preceding claims, wherein said ceramic superconducting layer (21) comprises a Y-Ba-Cu-0 superconducting layer.

11. A method according to claim 10, wherein said ceramic superconducting layer (21) comprises YBa_{2.1}Cu_{2.2}0_{7.1}.

## Patentansprüche

1. Verfahren zur Herstellung einer supraleitenden Mehrschichtschaltung mit mehreren supraleitenden Schichten, das folgende Schritte aufweist:
(1) epitaktisches Aufwachsen einer keramischen, supraleitenden Schicht (21) auf einem Substrat (20);
(2) Bilden eines Maskenmusters (22) auf einem Schaltungsabschnitt der keramischen, supraleitenden Schicht (21);
(3) Bedecken der Oberfläche der keramischen, supraleitenden Schicht (21) einschließlich des Schaltungsabschnittes mit dem darauf gebildeten Maskenmuster (22) und eines schaltungsfreien Abschnittes, der nicht das genannte Maskenmuster (22) auf sich gebildet trägt, mit einer Deckschicht (23a,23b), die ein modifizierendes Element zur Verringerung der kritischen Temperatur der keramischen, supraleitenden Schicht (21) aufweist;
(4) Entfernen des genannten Maskenmusters (22), zusammen mit der darauf gebildeten genannten Deckschicht (23a), vom Schaltungsabschnitt der keramischen, supraleitenden Schicht (21), um eine teilweise bedeckte keramische, supraleitende Schicht (21) zu bilden, die nach wie vor mit der Deckschicht (23b) im genannten schaltungsfreien Abschnitt überzogen ist;
(5) Erwärmen der teilweise bedeckten keramischen, supraleitenden Schicht (21), derart, daß das modifizierende Element von der Deckschicht (23b) in den schaltungsfreien Abschnitt der keramischen, supraleitenden Schicht (21) thermisch diffundiert wird, wodurch eine Schicht einer supraleitenden Schaltungsstruktur gebildet wird, die einen supraleitenden Schaltungsabschnitt und einen nicht supraleitenden schaltungsfreien Abschnitt umfaßt, wobei der genannte Schaltungsabschnitt eine kritische Temperatur von mehr als 77 K aufweist, während der schaltungsfreie Abschnitt eine kritische Temperatur unter 77 K sowie eine Kristallstruktur aufweist, die die gleiche oder eine ähnliche Struktur wie die des Schaltungsabschnittes ist; und
(6) mindestens einmaliges Wiederholen der Schritte (1) bis (5) auf der Schicht der supraleitenden Schaltungsstruktur, um so die supraleitende Mehrschichtschaltung herzustellen, die die genannten mehrfachen supraleitenden Schichten aufweist.

2. Verfahren nach Anspruch 1, bei dem das modifizierende Element in einer Menge eindiffundiert wird die es dem Supraleiter nach der Diffusion ermöglicht, dieselbe oder eine ähnliche Kristallstruktur aufzuweisen wie die des Supraleiters vor der Diffusion.

3. Verfahren nach Anspruch 1 oder 2, bei dem der keramische Supraleiter ein Supraleiter auf der Basis Y-Ba-Cu-O, ein Supraleiter auf der Basis Bi-Sr-Ca-Cu-O oder ein Supraleiter auf der Basis Tl-Ba-Ca-Cu-O ist.

4. Verfahren nach irgendeinem vorhergehenden Anspruch, bei dem das Maskenmuster (22) durch ein photolithographisches Verfahren gebildet wird.

5. Verfahren nach irgendeinem vorhergehenden Anspruch, bei dem die Deckschicht (23a,23b), welche das modifizierende Element enthält, durch Sputtern, Dampfabscheidungen oder Ionenplattieren gebildet wird.

6. Verfahren nach irgendeinem vorhergehenden Anspruch, bei dem das modifizierende Element mindestens eines der nachfolgenden Elemente Zn,Al,Ga,Fe,Co,Ni,La,Cd und Be ist.

7. Verfahren nach irgendeinem vorhergehenden Anspruch, bei dem der Erwärmungsschritt bei einer Temperatur von 200°C bis 1000°C durchgeführt wird.

8. Verfahren nach irgendeinem vorhergehenden Anspruch, bei dem eine Pufferschicht (26) zwischen den supraleitenden Schichten der supraleitenden Mehrschichtschaltung angebracht ist.

9. Verfahren nach Anspruch 8, bei dem die Pufferschicht (26) mindestens eine der Verbindungen MgO,SrTiO₃, AlGaO₃, ZnO₂, BaZrO₃ und LaAlO₂ umfaßt.

10. Verfahren gemäß irgendeinem vorhergehenden Anspruch, bei dem die keramische, supraleitende Schicht (21) eine supraleitende Schicht aus Y-Ba-Cu-O umfaßt.

11. Verfahren nach Anspruch 10, bei dem die keramische, supraleitende Schicht (21) die Verbindung YBa_{2.1}Cu_{2.2}O_{7.1} umfaßt.

## Revendications

1. Procédé pour former un circuit supraconducteur à couches multiples ayant de multiples couches supraconductrices, comportant les étapes consistant à :
(1) faire croître de manière épitaxialle une couche supraconductrice de céramique (21) sur un substrat (20);
(2) former un motif de masquage (22) sur une partie à circuit de ladite couche supraconductrice de céramique (21);
(3) recouvrir la surface de ladite couche supraconductrice de céramique (21), comprenant ladite partie à circuit ayant ledit motif de masquage (22) formé sur son dessus et une partie sans circuit n'ayant pas ledit motif de masquage (22) formé sur son dessus, avec une couche de couverture (23a, 23b) comprenant un élément de modification afin d'abaisser la température critique de ladite couche supraconductrice de céramique (21);
(4) enlever de ladite partie à circuit de ladite couche supraconductrice de céramique (21) ledit motif de masquage (22) en même temps que ladite couche de couverture (23a) formée sur son dessus pour réaliser une couche supraconductrice de céramique partiellement recouverte (21) toujours recouverte par ladite couche de couverture (23b) dans ladite partie sans circuit;
(5) chauffer ladite couche supraconductrice de céramique partiellement recouverte (21) de manière à diffuser thermiquement ledit élément de modification pour le faire passer de ladite couche de couverture (23b) à ladite partie sans circuit de ladite couche supraconductrice de céramique (21), d'où la formation d'une couche d'une structure de circuit supraconductrice comportant une partie à circuit supraconducteur et une partie sans circuit non supraconducteur, ladite partie à circuit ayant une température critique supérieure à 77 K, et ladite partie sans circuit ayant une température critique inférieure à 77 K et une structure cristalline identique ou similaire à celle de la partie à circuit; et
(6) répéter au moins une fois sur ladite couche de ladite structure à circuit supraconducteur lesdites étapes (1) à (5) afin de former ainsi ledit circuit supraconducteur à couches multiples ayant lesdites multiples couches supraconductrices.

2. Procédé selon la revendication 1, dans lequel ledit élément de modification est diffusé dans une quantité qui permet au supraconducteur après la diffusion d'avoir une structure cristalline identique ou similaire à celle du supraconducteur avant la diffusion.

3. Procédé selon la revendication 1 ou 2, dans lequel ledit supraconducteur de céramique est un supraconducteur à base de Y-Ba-Cu-O, un supraconducteur à base de Bi-Sr-Ca-Cu-O ou un supraconducteur à base de Tl-Ba-Ca-Cu-O.

4. Procédé selon l'une quelconque des revendications précédentes, dans lequel ledit motif de masquage (22) est formé par un procédé photolithographique.

5. Procédé selon l'une quelconque des revendications précédentes, dans lequel ladite couche de couverture (23a, 23b), contenant ledit élément de modification, est formée par crépitement, déposition en phase vapeur ou revêtement ionique.

6. Procédé selon l'une quelconque des revendications précédentes, dans lequel ledit élément de modification est au moins l'un des éléments : Zn, Al, Ga, Fe, Co, Ni, La, Cd et Be.

7. Procédé selon l'une quelconque des revendications précédentes, dans lequel l'étape de chauffage est exécutée à une température de 200° C à 1000° C.

8. Procédé selon l'une quelconque des revendications précédentes, dans lequel une couche tampon (26) est fournie entre lesdites couches supraconductrices dudit circuit supraconducteur à couches multiples.

9. Procédé selon la revendication 8, dans lequel ladite couche tampon (26) comprend au moins l'un des composés suivants : MgO, SrTiO₃, AlGaO₃, ZnO₂, BaZrO₃ et LaAlO₂.

10. Procédé selon l'une quelconque des revendications précédentes, dans lequel ladite couche supraconductrice de céramique (21) comprend une couche supraconductrice de Y-Ba-Cu-O.

11. Procédé selon la revendication 10, dans lequel ladite couche supraconductrice de céramique (21) comprend YBa_{2,1}Cu_{2,2}O_{7,1}.
